# EUROPÄISCHE PATENTANMELDUNG

(11) **EP 4 498 772 A1**
(43) Veröffentlichungstag der Anmeldung: **29.01.2025**
(21) Anmeldenummer: 23188457.8
(22) Anmeldetag: 28.07.2023
(51) Int. Cl.: H05K 7/14, H01R 12/71, H01R 4/30, H01R 12/70, H01R 12/55

(54) **ELEKTRONISCHE LEISTUNGSBAUGRUPPE MIT VERBESSERTEM AUFBAU**

(71) Anmelder: Siemens Aktiengesellschaft, 80333 München (DE)
(72) Erfinder: Frana, Christian, 90556 Cadolzburg (DE); Rövenstrunck, Martin, 91126 Schwabach (DE); Saufhaus, Tim, 91462 Dachsbach (DE); Uthmann, Tom, 91320 Ebermannstadt (DE); Uttenreuther, Sandro, 91301 Forchheim (DE)
(74) Vertreter: Siemens Patent Attorneys

(57) **Zusammenfassung**

Eine elektronische Leistungsbaugruppe, beispielsweise eine Umrichtereinheit, weist eine Leiterplatte (1) mit einer Oberseite (2) und einer Unterseite (3) auf. Die Leiterplatte (1) weist Leiterbahnen (4) zum Führen von Leistungsströmen auf. Sie weist weiterhin eine Anzahl von Ausnehmungen (5) auf, durch die hindurch Gewindeschrauben (6) geführt sind, so dass Schraubenköpfe (7) der Gewindeschrauben (6) an der Oberseite (2) der Leiterplatte (1) anliegen und Gewinde (8) der Gewindeschrauben (6) über die Unterseite (3) der Leiterplatte (1) überstehen. Die Gewinde (8) sind in Stecker (9) von Steckverbindungen zum Übertragen von Leistungsströmen eingedreht, so dass die Stecker (9) an die Unterseite (3) der Leiterplatte (1) angedrückt sind. Die Stecker (9) sind in Steckerbuchsen (11) eingeführt. Die Steckerbuchsen (11) sind in einer Buchsenhalterung (12) angeordnet, die ihrerseits an einem unterhalb der Leiterplatte (1) angeordneten mechanischen Tragelement (15) für die Buchsenhalterung (12) befestigt ist.

## Beschreibung

Die vorliegende Erfindung geht aus von einer elektronischen Leistungsbaugruppe, insbesondere einer Umrichtereinheit,
- wobei die Leistungsbaugruppe eine Leiterplatte mit einer Oberseite und einer Unterseite aufweist,
- wobei die Leiterplatte Leiterbahnen zum Führen von Leistungsströmen aufweist,
- wobei die Leiterplatte eine Anzahl von Ausnehmungen aufweist,
- wobei Gewindeschrauben durch die Ausnehmungen hindurch geführt sind, so dass Schraubenköpfe der Gewindeschrauben an der Oberseite der Leiterplatte anliegen und Gewinde der Gewindeschrauben über die Unterseite der Leiterplatte überstehen.

Derartige Leistungsbaugruppen sind allgemein bekannt. Sie werden beispielsweise als Stromversorgungseinrichtungen für elektrische Antriebe eingesetzt.

Gewindeschrauben können zu den verschiedensten Zwecken, beispielsweise zur (ausschließlich) mechanischen Befestigung der Leiterplatte in einem Gehäuse oder zur Kontaktierung elektrischer Anschlüsse, eingesetzt werden. Eine elektrische Kontaktierung bewirkt zwar auch eine mechanische Verbindung, dies ist jedoch nicht der Zweck der elektrischen Kontaktierung.

In der Technik besteht allgemein das Bestreben, immer mehr Inhalt in immer weniger Volumen unterzubringen. Bei elektronischen Leistungsbaugruppe bedeutet dies, dass die Packungsdichte und die Leistungsdichte entsprechend erhöht werden.

Aufgrund der Erhöhung der Packungsdichte und der Leistungsdichte rücken Bauelemente, mechanische Verbindungen, elektrische Verbindungen und Kontaktstellen immer näher aneinander. In Verbindung mit unvermeidbaren Einbautoleranzen und sonstigen Toleranzen kann dies dazu führen, dass in kleinen Bereichen hohe mechanische Verspannungen auf empfindliche Bauteile wie beispielsweise Leiterplatten oder Leistungshalbleitermodule wirken können. Derartige mechanische Verspannungen können auf Dauer zu Schäden führen und sollten daher so weit wie möglich vermieden werden.

Im Stand der Technik sind die mechanischen Verspannungen oftmals hinnehmbar, weil die geometrischen Abstände der Bauelemente, der mechanischen und elektrischen Verbindungen und der Kontaktstellen voneinander groß genug sind. Mit der zunehmenden Erhöhung der Leistungsdichte ist die elastische Verformung, die toleriert werden kann, jedoch nur noch sehr gering.

Eine Möglichkeit zur Lösung dieses Problems besteht darin, mit geringeren Toleranzen zu arbeiten. Diese Lösung ist jedoch sehr kostenaufwendig und wird daher in der Praxis nach Möglichkeit nicht beschritten.

Eine weitere Möglichkeit besteht darin, für elektrische Verbindungen Kabel zu verwenden. Kabel sind flexibel, so dass sie auch Toleranzen ausgleichen können. Kabel sind jedoch prozesstechnisch schwer zu verarbeiten. Insbesondere eine automatisierte Fertigung ist oftmals nicht möglich.

Die Aufgabe der vorliegenden Erfindung besteht darin, eine elektronische Baugruppe der eingangs genannten Art derart weiterzuentwickeln, dass trotz einer hohen Packungsdichte und Leistungsdichte elastische Verformungen von kritischen Bauteilen vollständig oder zumindest weitgehend vermieden werden können.

Die Aufgabe wird durch eine elektronische Leistungsbaugruppe mit den Merkmalen des Anspruchs 1 gelöst. Vorteilhafte Ausgestaltungen der elektronischen Leistungsbaugruppe sind Gegenstand der abhängigen Ansprüche 2 bis 4.

Erfindungsgemäß wird eine elektronische Leistungsbaugruppe der eingangs genannten Art dadurch ausgestaltet,
- dass die Gewinde in Stecker von Steckverbindungen zum Übertragen von Leistungsströmen eingedreht sind, so dass die Stecker an die Unterseite der Leiterplatte angedrückt sind,
- dass die Stecker in Steckerbuchsen eingeführt sind und
- dass die Steckerbuchsen in einer Buchsenhalterung angeordnet sind, die ihrerseits an einem unterhalb der Leiterplatte angeordneten mechanischen Tragelement für die Buchsenhalterung befestigt ist.

Durch das Zusammenwirken der Gewindeschrauben mit den Steckern ist auch gewährleistet, dass die Schraubenköpfe an die Oberseite und die Stecker an die Unterseite der Leiterplatte angedrückt sind. Dadurch sind insbesondere die Stecker mechanisch präzise (spielfrei) fixiert. Soweit ein elektrischer Kontakt zur Oberseite und/oder zur Unterseite der Leiterplatte hergestellt werden soll, ist weiterhin auch ein guter elektrischer Kontakt gewährleistet.

Durch die Verwendung von Steckern und Steckerbuchsen ergibt sich direkt ein Toleranzausgleich zwischen der Anordnung der Leiterplatte einerseits und der Anordnung der Buchsenhalterung andererseits. Denn unabhängig davon, ob ein jeweiliger Stecker vollständig oder nur teilweise in eine Steckerbuchse eingeführt ist, ergibt sich ein guter elektrischer Kontakt zwischen Stecker und Steckerbuchse. Eine Ausnahme kann sich nur dann ergeben, wenn der Stecker nur ganz minimal in die Steckerbuchse eingeführt ist. Dieser Sachverhalt kann im Rahmen der vorliegenden Erfindung jedoch vernachlässigt werden.

Die von den Leiterbahnen der Leiterplatte geführten Leistungsströme und auch die über die Steckverbindungen übertragenen Leistungsströme liegen in aller Regel bei 10 A und mehr. Oftmals liegen sie bei 100 A oder darüber, manchmal bei mehreren 100 A, in extremen Fällen sogar bei über 1 kA. Schaltelemente zum Schalten der Leistungsströme sind meist entweder direkt auf der Leiterplatte angeordnet oder auf einem Substrat angeordnet, das seinerseits auf der Oberseite oder der Unterseite der Leiterplatte angeordnet ist. Mittels der Schaltelemente werden in der Regel Spannungen von 100 V und mehr geschaltet, meist Spannungen von mehreren 100 V, in manchen Fällen sogar Spannungen oberhalb von 1 kV, im Extremfall bis zu 3,0 kV oder 3,3 kV. Im gleichen Ausmaß kann im Laufe der Zeit auch das Potenzial variieren, das eine bestimmte derartige Leiterbahn bzw. eine bestimmte Steckverbindung aufweist bzw. führt.

Steckverbindungen, die für das Führen der erforderlichen Leistungsströme geeignet sind, sind als solche bekannt. Rein beispielhaft kann auf die DE 10 2021 119 087 A1 und auf die DE 10 2021 119 087 A1 verwiesen werden.

Vorzugsweise ist ein minimaler Abstand unmittelbar benachbarter Steckerbuchsen in der Buchsenhalterung kleiner als ein Außendurchmesser der Steckerbuchsen. Dadurch kann die Anzahl an Steckerbuchsen, die auf einem bestimmten Raum angeordnet werden kann, maximiert werden.

Vorzugsweise sind in der Buchsenhalterung mindestens vier Steckerbuchsen in einer Reihe nebeneinander angeordnet. Insbesondere bei einem derartigen Sachverhalt zeigen sich die Vorteile der vorliegenden Erfindung. Denn üblicherweise können die Verbindungselemente, unabhängig davon, ob sie als Steckerbuchsen oder anderweitig ausgebildet sind, bereits in der Buchsenhalterung selbst nur mit relativ hohen Toleranzen angeordnet werden. Bereits bei nur wenigen Steckerbuchsen würde daher, wenn die Verbindungselemente anderweitig ausgebildet wären, oftmals eine völlig inakzeptable mechanische Verspannung der Leiterplatte die Folge sein.

Die Anzahl an Steckerbuchsen liegt oftmals bei sechs. Grund hierfür ist, dass oftmals drei Phasen vorhanden sind und jeweils eine Drossel über jeweils zwei Steckerbuchsen in einen entsprechenden Strompfad eingeschleift ist.

Vorzugsweise ist zwischen der Leiterplatte und dem mechanischen Tragelement eine Isolierstruktur angeordnet, welche die Leiterplatte von dem Tragelement elektrisch isoliert. Dadurch können elektrische Luft- und Kriechstrecken maximiert werden. Die Isolierstruktur besteht in der Regel aus Kunststoff.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die in Verbindung mit den Zeichnungen näher erläutert werden. Hierbei zeigen in schematischer Darstellung:
- FIG 1: Bestandteile einer elektronischen Leistungsbaugruppe von der Seite,
- FIG 2: eine Draufsicht auf eine Leiterplatte,
- FIG 3: ein Detail von FIG 1 aus einer in FIG 1 mit III-III bezeichneten Richtung und
- FIG 4: eine einzelne Steckverbindung.

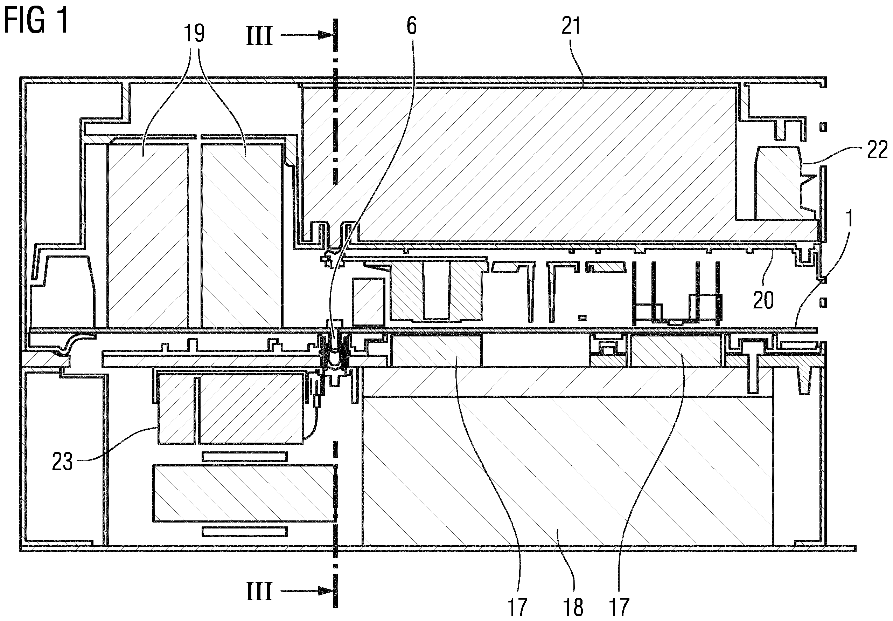

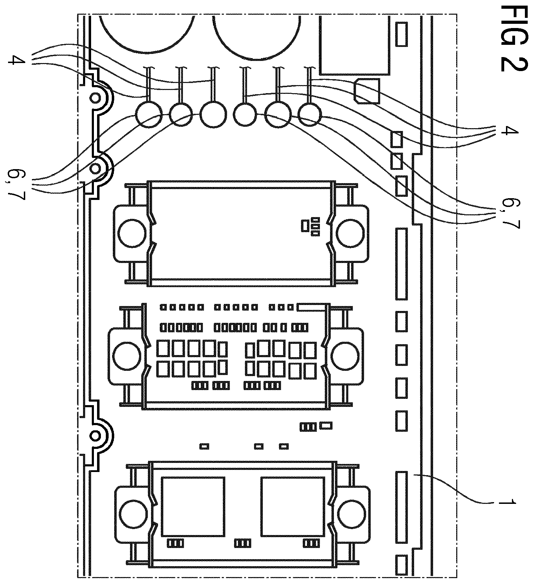

Gemäß FIG 1 weist eine elektronische Leistungsbaugruppe eine Leiterplatte 1 auf. Die Leistungsbaugruppe kann beispielsweise eine Umrichtereinheit sein. Die Leiterplatte 1 weist eine Oberseite 2 und eine Unterseite 3 auf. Die Leiterplatte 1 weist weiterhin gemäß FIG 2 Leiterbahnen 4 auf. Die Leiterbahnen 4 dienen zum Führen von Leistungsströmen. Sie können nach Bedarf auf der Oberseite 2 und/oder auf der Unterseite 3 Leiterplatte 1 angeordnet sein. Von den Leiterbahnen 4 sind in FIG 2 nur einige dargestellt, und auch von den dargestellten Leiterbahnen 4 sind nur Abschnitte dargestellt.

Die Leiterplatte 1 weist oftmals auch weitere Leiterbahnen auf, welche Steuersignale führen. Die weiteren Leiterbahnen sind vorliegend nicht relevant. Sie sind daher nicht dargestellt und werden nachstehend auch nicht betrachtet.

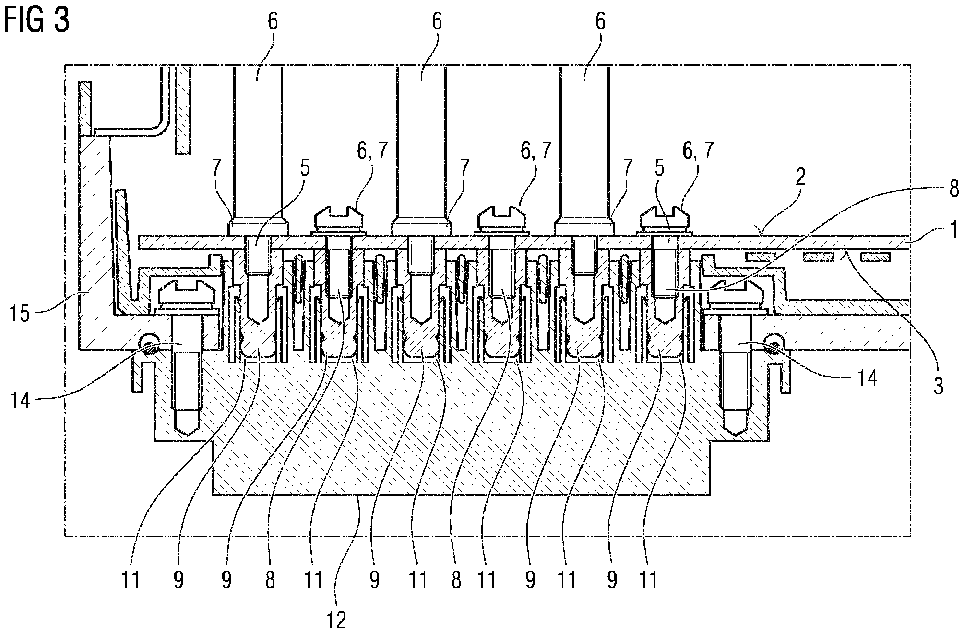

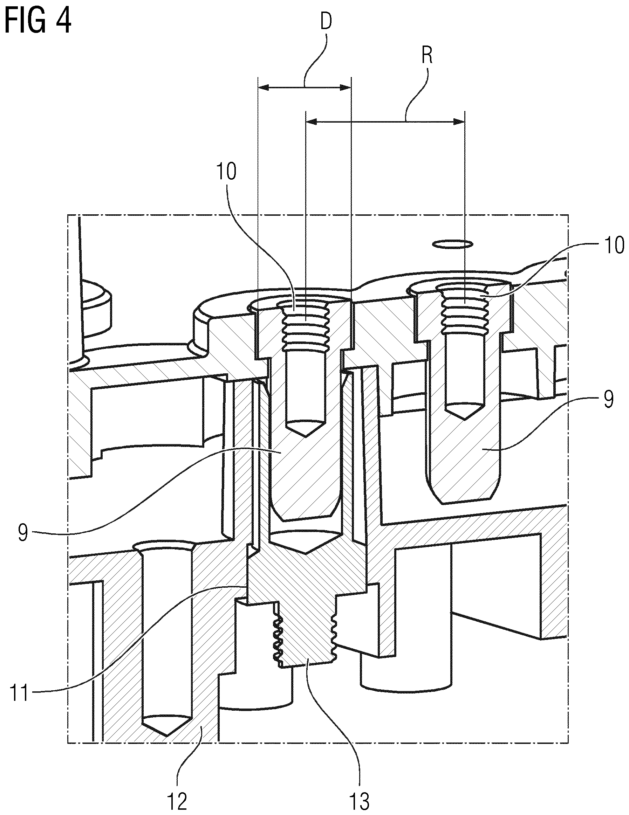

Die Leiterplatte 1 weist - siehe insbesondere FIG 3 - weiterhin eine Anzahl von Ausnehmungen 5 auf. Durch die Ausnehmungen 5 hindurch sind Gewindeschrauben 6 geführt, die Schraubenköpfe 7 und Gewinde 8 aufweisen. Die Schraubenköpfe 7 liegen an der Oberseite 2 der Leiterplatte 1 an. Die Gewinde 8 der Gewindeschrauben 6 stehen über die Unterseite 3 der Leiterplatte 1 über. Insbesondere sind die Gewinde 8 in Stecker 9 eingedreht, die entsprechend der Darstellung in FIG 4 zu diesem Zweck entsprechende Gewindebohrungen 10 aufweisen. Dadurch sind die Stecker 9 an die Unterseite 3 der Leiterplatte 1 angedrückt. Gleichzeitig sind auch die Schraubenköpfe 7 an die Oberseite 2 der Leiterplatte 1 angedrückt.

Die Stecker 9 wiederum sind in Steckerbuchsen 11 eingeführt. Die Steckerbuchsen 11 bilden zusammen mit den Steckern 9 jeweils eine Steckverbindung zum Übertragen eines Leistungsstroms. Die Steckerbuchsen 11 sind in einer Buchsenhalterung 12 angeordnet. Beispielsweise können die Steckerbuchsen 11 entsprechend der Darstellung in FIG 4 an ihrer Unterseite ein Gewinde 13 aufweisen, mit dem sie in die Buchsenhalterung 12 eingeschraubt sind. Die Buchsenhalterung 12 ist über Befestigungselemente 14 an einem mechanischen Tragelement 15 für die Buchsenhalterung 12 befestigt. Das mechanische Tragelement 15 ist unterhalb der Leiterplatte 1 angeordnet.

Die FIG 1 bis 3 zeigen den fertigen Zustand der elektronischen Leistungsbaugruppe. Zum Herstellen der elektronischen Leistungsbaugruppe ist es möglich, zunächst die Stecker 9 mittels der Gewindeschrauben 6 an der Unterseite 3 der Leiterplatte 1 zu befestigen und dann die Leiterplatte 1 so zu führen, dass die Stecker 9 in die Steckerbuchsen 11 eingeführt werden. Die Steckerbuchsen 11 sind zu diesem Zeitpunkt bereits in der Buchsenhalterung 12 angeordnet sind und die Buchsenhalterung 12 ist zu diesem Zeitpunkt bereits an dem Tragelement 15 befestigt. Vorzugsweise wird jedoch eine andere Vorgehensweise ergriffen. Das Anordnen der Steckerbuchsen 11 in der Buchsenhalterung 12 und das Befestigen der Buchsenhalterung 12 an dem Tragelement 15 bleiben unverändert. Jedoch sind die Stecker 9 in den Steckerbuchsen 11 angeordnet. Sodann wird die Leiterplatte 1 auf die vollständigen Steckverbindungen aufgesetzt. Erst danach werden die Gewinde 8 der Gewindeschrauben 6 in die Gewindebohrungen 10 eingedreht.

Gemäß FIG 4 weisen die Steckerbuchsen 11 einen Außendurchmesser D auf. Der Außendurchmesser D ist derjenige Durchmesser, den die Steckerbuchsen 11 in einer Steckrichtung der Stecker 9 gesehen in demjenigen Bereich aufweisen, in welchen die Stecker 9 eingeführt werden. Weiterhin sind unmittelbar benachbarte Steckerbuchsen 11 in der Buchsenhalterung 12 in einem Rastermaß R angeordnet. Das Rastermaß R ist der Abstand von der Mitte einer Steckerbuchse 11 zur Mitte der nächsten Steckerbuchse 11. Entsprechend der Darstellung in FIG 4 kann das Rastermaß R kleiner als das Doppelte des Durchmessers D sein. In diesem Fall weisen unmittelbar benachbarte Steckerbuchsen 11 einen minimalen Abstand R-D voneinander auf, der kleiner als der Außendurchmesser D ist.

Weiterhin sind gemäß FIG 3 in der Buchsenhalterung 12 mindestens vier - konkret sogar sechs - Steckerbuchsen 11 in einer Reihe nebeneinander angeordnet.

Auch ist insbesondere aus FIG 3 erkennbar, dass zwischen der Leiterplatte 1 und dem mechanischen Tragelement 13 eine Isolierstruktur 16 angeordnet ist. Die Isolierstruktur 16 bewirkt eine elektrische Isolierung der Leiterplatte 1 von dem Tragelement 15.

FIG 1 zeigt die gesamte Leistungsbaugruppe. Insbesondere sind in FIG 1 zusätzlich zu den bisher erläuterten Komponenten weitere Bestandteile erkennbar. Diese Bestandteile müssen nicht alle vorhanden sein und sind im Rahmen der vorliegenden Erfindung von untergeordneter Bedeutung.

Beispielsweise kann die Leistungsbaugruppe folgende zusätzliche Komponenten umfassen:
- Leistungsmodule 17, mittels derer die Leistungsströme geschalten werden. Die Leistungsmodule 17 umfassen Schaltelemente wie Transistoren oder Thyristoren. Die genaue Bauart der Transistoren oder Thyristoren kann nach Bedarf sein, beispielsweise bei Transistoren als Bipolartransistoren, als IGBT oder als FET.
- Einen Kühlkörper 18 zum Kühlen der Leistungsmodule 17.
- Pufferkondensatoren 19, meist in der Form von Elektrolytkondensatoren. Die Pufferkondensatoren 19 erfüllen in der Regel die Funktion von Zwischenkreiskondensatoren eines Gleichspannungskreises.
- Eine mechanische Brückenstruktur 20, die auf der Leiterplatte 1 befestigt ist. Die Brückenstruktur 20 besteht aus einem elektrisch isolierenden Material, insbesondere einem Kunststoff. Die Befestigung kann nach Bedarf erfolgen. Die Brückenstruktur 20 weist an ihrer Oberseite eine Auflagefläche auf.
- Eine oberhalb der Leiterplatte 1 angeordnete Zusatzeinheit 21. Die Zusatzeinheit 21 weist elektronische Komponenten (nicht dargestellt) auf. Die elektronischen Komponenten können beispielsweise eine in Umrichtereinheiten übliche Filterschaltung bilden. Die Zusatzeinheit 21 liegt auf der Auflagefläche der Brückenstruktur 20 auf.
- Einen Anschlussblock 22 für eine externe Leitungsführung, beispielsweise zu einer elektrischen Maschine.
- In die Stromführung der elektronischen Leistungsbaugruppe eingebundene Zusatzelemente 23. Die Zusatzelemente 23 können insbesondere als Drosseln ausgebildet sein. Insbesondere die Einbindung derartiger Zusatzelemente 23 kann über die Steckverbindungen erfolgen.

Zusammengefasst betrifft die vorliegende Erfindung somit folgenden Sachverhalt:
Eine elektronische Leistungsbaugruppe, beispielsweise eine Umrichtereinheit, weist eine Leiterplatte 1 mit einer Oberseite 2 und einer Unterseite 3 auf. Die Leiterplatte 1 weist Leiterbahnen 4 zum Führen von Leistungsströmen auf. Sie weist weiterhin eine Anzahl von Ausnehmungen 5 auf, durch die hindurch Gewindeschrauben 6 geführt sind, so dass Schraubenköpfe 7 der Gewindeschrauben 6 an der Oberseite 2 der Leiterplatte 1 anliegen und Gewinde 8 der Gewindeschrauben 6 über die Unterseite 3 der Leiterplatte 1 überstehen. Die Gewinde 8 sind in Stecker 9 von Steckverbindungen zum Übertragen von Leistungsströmen eingedreht, so dass die Stecker 9 an die Unterseite 3 der Leiterplatte 1 angedrückt sind. Die Stecker 9 sind in Steckerbuchsen 11 eingeführt. Die Steckerbuchsen 11 sind in einer Buchsenhalterung 12 angeordnet, die ihrerseits an einem unterhalb der Leiterplatte 1 angeordneten mechanischen Tragelement 15 für die Buchsenhalterung 12 befestigt ist.

Die vorliegende Erfindung weist viele Vorteile auf. Insbesondere können mechanische Verspannungen auf einfache Art und Weise vollständig oder zumindest nahezu vollständig vermieden werden. Weiterhin vereinfacht sich die Montage der elektronischen Leistungsbaugruppe.

Obwohl die Erfindung im Detail durch das bevorzugte Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

## Patentansprüche

1. Elektronische Leistungsbaugruppe, insbesondere Umrichtereinheit,
- wobei die Leistungsbaugruppe eine Leiterplatte (1) mit einer Oberseite (2) und einer Unterseite (3) aufweist,
- wobei die Leiterplatte (1) Leiterbahnen (4) zum Führen von Leistungsströmen aufweist,
- wobei die Leiterplatte (1) eine Anzahl von Ausnehmungen (5) aufweist,
- wobei Gewindeschrauben (6) durch die Ausnehmungen (5) hindurch geführt sind, so dass Schraubenköpfe (7) der Gewindeschrauben (6) an der Oberseite (2) der Leiterplatte (1) anliegen und Gewinde (8) der Gewindeschrauben (6) über die Unterseite (3) der Leiterplatte (1) überstehen,
**dadurch gekennzeichnet,**
- **dass** die Gewinde (8) in Stecker (9) von Steckverbindungen zum Übertragen von Leistungsströmen eingedreht sind, so dass die Stecker (9) an die Unterseite (3) der Leiterplatte (1) angedrückt sind,
- **dass** die Stecker (9) in Steckerbuchsen (11) eingeführt sind
und
- **dass** die Steckerbuchsen (11) in einer Buchsenhalterung (12) angeordnet sind, die ihrerseits an einem unterhalb der Leiterplatte (1) angeordneten mechanischen Tragelement (15) für die Buchsenhalterung (12) befestigt ist.

2. Leistungsbaugruppe nach Anspruch 1,
**dadurch gekennzeichnet,**
**dass** ein minimaler Abstand unmittelbar benachbarter Steckerbuchsen (11) in der Buchsenhalterung (12) kleiner als ein Außendurchmesser (D) der Steckerbuchsen (11) ist.

3. Leistungsbaugruppe nach Anspruch 1 oder 2,
**dadurch gekennzeichnet,**
**dass** in der Buchsenhalterung (12) mindestens vier Steckerbuchsen (11) in einer Reihe nebeneinander angeordnet sind.

4. Leistungsbaugruppe nach Anspruch 1, 2 oder 3,
**dadurch gekennzeichnet,**
**dass** zwischen der Leiterplatte (1) und dem mechanischen Tragelement (15) eine Isolierstruktur (16) angeordnet ist, welche die Leiterplatte (1) von dem Tragelement (15) elektrisch isoliert.
